(19)

Europäisches
Patentamt
European
Patent Office
Office européen
des brevets

(11) **EP 4 503 439 A1**

(12) **EUROPEAN PATENT APPLICATION**

(43) Date of publication:
**05.02.2025 Bulletin 2025/06**

(21) Application number: **23189123.5**

(22) Date of filing: **02.08.2023**

(51) International Patent Classification (IPC):
**H03K 17/14** (2006.01)    **H03K 17/18** (2006.01)
**H10N 70/20** (2023.01)

(52) Cooperative Patent Classification (CPC):
**H03K 17/18; G11C 13/0069; H03K 17/14;**
G11C 13/0004; G11C 2013/0066; G11C 2013/008

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Infineon Technologies AG
85579 Neubiberg (DE)**

(72) Inventors:
• **PFLAUM, Bernd
82008 Unterhaching (DE)**
• **BAENISCH, Andreas
82031 Grünwald (DE)**
• **HEISS, Dominik
80799 München (DE)**

(74) Representative: **Kraus & Lederer PartGmbB
Thomas-Wimmer-Ring 15
80539 München (DE)**

(54) **CONTROLLER FOR PHASE CHANGE SWITCH DEVICE, SYSTEM AND METHODS**

(57)    A controller (11) for a phase change switch device (12), a system (10) including such a controller (11) and a phase change switch device (12) and a corresponding method are provided. The controller (11) comprises a control input (13) to receive a first control signal (c1) indicating a desired state of the phase change switch device (12) and a measurement input (14) configured to receive a measurement signal (m) indicating an actual state of the phase change switch device (12). A control logic (16) is configured to generate a second control signal (c2) based on the first control signal (c1) and the measurement signal (m), and the controller (11) further includes a control output (15) configured to output the second control signal (c2) to at least one heater (18) of the phase change switch device (12).

Fig. 1

**Description**

TECHNICAL FIELD

The present application relates to controllers for phase change switch devices, systems including such a controller and a phase change switch device, and to corresponding methods.

BACKGROUND

The technical requirements for radio frequency (RF) applications using high frequencies, such as radar sensing and mobile communication according to the 5G standard, are increasing. In particular, switches having improved characteristics compared to state-of-the-art CMOS switches will be required to meet future demands. Phase change switches are considered as promising candidates for switching RF signals. Such phase change switches use a phase change material (PCM) which typically exhibits a higher electric conductivity in a crystalline phase state than in an amorphous phase state. By changing the phase state of the phase change material, a switch device including such a material may be switched on and off.

For example, to change the phase state from amorphous to crystalline, typically a heater is employed heating the phase change material causing crystallization. This switching on by causing crystallization is also referred to as a set operation. In the set operation, the heater is actuated in such a way that the temperature of the phase change material is above its crystallization temperature, typically about 250°C, but below the melt temperature, typically in a range of 600°C to 900°C, for example. The length of the heating pulse caused by the heater is chosen such that any amorphous region present in the PCM can regrow into the crystalline phase state.

When switching off the switching device, also referred to as reset operation, the heater is actuated in such a way that the temperature of the PCM is raised above the melt temperature (for example above about 600°C to 900°C) followed by a comparatively rapid cooldown which freezes the phase change material into an amorphous state.

Suitable phase change materials used for such phase change switches include germanium telluride (GeTe) or germanium-antimony-tellurium (GeSbTe, usually referred to as GST), and heaters may be made of a material like polycrystalline silicon or tungsten, or may include a semiconductor device like a pin diode.

Therefore, depending on time duration and electrical power provided to the heater, the switch may perform a set operation or a reset operation.

The timing and power requirements as well as requirements regarding the resulting temperature are determined by the material and structure of the phase change switch, for example depending on the phase change material, material of the heater, thermal coupling of the heater to the phase change material, etc. It may also vary with device parameter variations due to manufacturing tolerances (for example varying thermal coupling due to processing tolerances) or external influences. For example, if the temperature of the phase change material before heating is higher due to a higher ambient temperature, heating by nearby other devices or the like, less power supplied to a heater may be required.

SUMMARY

A controller for a phase change switch device as defined in claim 1 and a system as defined in claim 9 are provided. The dependent claims define further embodiments.

According to an embodiment, a controller for a phase change switch device is provided, comprising:

a control input configured to receive a first control signal indicating a desired state of the phase change switch device,
a measurement input configured to receive a measurement signal indicating an actual state of the measurement device,
a control output configured to output a second control signal to at least one heater of the phase change switch device, and
a control logic configured to generate the second control signal based on the first control signal and the measurement signal.

According to a further embodiment, a system comprising a controller as mentioned above and the phase change switch device is provided.

According to a further embodiment, a method is provided, comprising:

receiving a first control signal indicating a desired state of a phase change switch device,
receiving a measurement signal indicating an actual state of the phase change switch device, and
output a second control signal for controlling a heater of the phase change switch device based on the first control signal and the measurement signal.

The above summary is merely intended as a brief overview over some embodiments and is not to be construed as limiting in any way, as other embodiments may include different features from the ones listed above.

BRIEF DESCRIPTION OF THE DRAWINGS

Fig. 1 is a block diagram of a system according to an embodiment, including a controller according to an embodiment.

Fig. 2 is a flowchart illustrating a method according to an embodiment.

Fig. 3 is a timing diagram illustrating controlling of a phase change switch device according to some embodiments.

Fig. 4 is a diagram illustrating a system according to a further embodiment.

Fig. 5 is a diagram illustrating a controller according to an embodiment.

Figures 6 and 7 are circuit diagrams illustrating at least part of controllers according to some embodiments.

Fig. 8 is a circuit diagram illustrating a system according to an embodiment.

Figures 9A and 9B are diagrams illustrating systems according to different embodiments.

Fig. 10 is a diagram illustrating a controller according to an embodiment.

Fig. 11 is a diagram illustrating a system according to an embodiment.

Fig. 12 is a diagram illustrating a system according to an embodiment.

Fig. 13 is a diagram of a system according to a further embodiment.

Fig. 14 is a diagram illustrating the use of auxiliary switches.

Fig. 15A and 15B are diagrams illustrating systems according to various embodiments.

DETAILED DESCRIPTION

In the following, various embodiments will be described in detail referring to the attached drawings. The embodiments described hereinafter are to be taken as examples only and are not to be construed as limiting. For example, while in embodiments specific arrangements or components are provided, in other embodiments other configurations may be used.

In the following, a coupling between a heater and a phase change material refers to thermal coupling, such that the heater may heat the phase change material. Otherwise, connections or couplings described herein refer to electrical connections or couplings unless noted otherwise. Such electrical connections or couplings may be modified, for example by adding or removing circuit elements, as long as the general function of the connection or coupling, for example to provide a certain kind of signal or a certain kind of control, is essentially maintained. For example, in the following controllers will be described outputting a control signal to a heater to cause the heater to heat a phase change material. Such a control signal may be directly provided to the heater by the controller, for example be a current flowing through the heater, therefore heating up the heater material. It may also be provided indirectly to the heater, for example via elements like drivers, amplifiers, or other circuit elements, to ultimately cause a heating of the heater, for example by providing a current to the heater by a driver in response to the control signal.

Besides features (for example components, elements, acts, events or the like) explicitly shown and described, in other embodiments additional features may be provided, for example features used in conventional phase change material switch devices. For example, some embodiments herein focus on providing a measurement signal indicating a state of a phase change switch and generating a control signal correspondingly, while other features, for example spatial arrangement of heaters and phase change material, radio frequency (RF) circuitry using the phase change switch device and the like may be implemented in a conventional manner. Such RF circuitry may be integrated with the described systems or parts thereof are the same substrate but may also be provided separately for example on one or more separate chip dies which in some implementations may then be combined with systems or part of systems herein in a common package. Also, a controller as discussed below may be integrated with a phase change switch device, provided in a common package with the phase change switch device, or provided in a separate package.

Furthermore, manufacturing steps for implementing the systems and devices shown like providing phase change material on a substrate like a silicon substrate to implement a phase change switch, providing phase change material in a trench in a silicon substrate for manufacturing the phase change switch and the like may be performed in any conventional manner.

A switch based on a phase change material (PCM) will be referred to as phase change switch or PCM switch herein. A phase change switch device may include one or more of such phase change switches. As explained in the introductory portion, such phase change switches may be set to a crystalline phase state or an amorphous phase state, thus changing the resistance of the phase change material and therefore of the switch by several orders of magnitudes. In this way, for example in an on-state an on-resistance of a phase change switch in a range of 1 to 100 $\Omega$ may be achieved, whereas an off-resistance in an off-state may be several orders of magnitude higher, for example at least in the Kiloohm range.

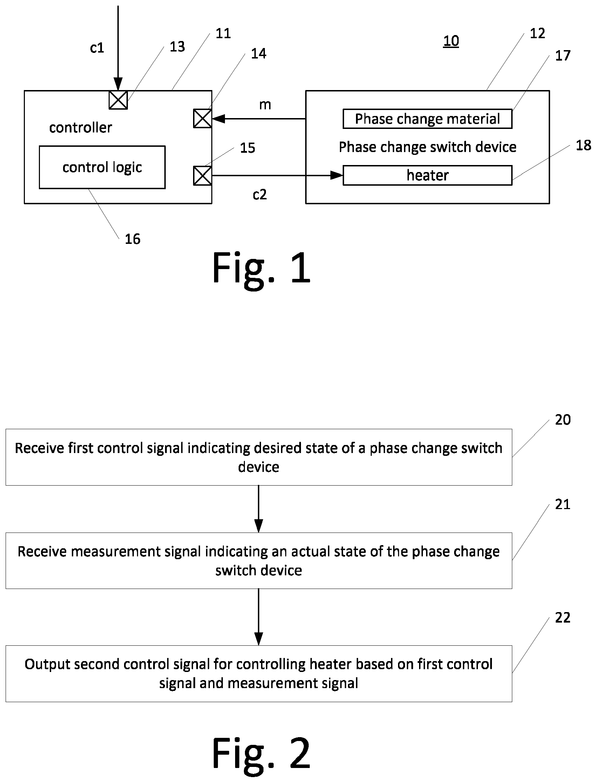

Turning now to the Figures, Fig. 1 is a block diagram illustrating a system 10 according to an embodiment. System 10 comprises a controller 11 and a phase change switch device 12. Phase change switch device 12 may essentially be any conventional phase change switch device and comprises at least one phase change switch including a phase change material 17 and a heater 18 thermally coupled to phase change material 17, to heat phase change material 17 in order to perform the above explained set and reset operations.

Controller 11 controls heater 18. Controller 11 comprises a control input 13 to receive a first control signal c1 indicating a desired state of the phase change switch device, i.e. a state to which phase change device 12 should be brought (on or off). For example, first control signal c1 may be received from another controller controlling operation of an apparatus where phase change switch device 12 is incorporated, for example for antenna tuning purposes or other radio frequency applications, and decides to which state phase change switch device is to be brought for operation of the apparatus. In some embodiments, control input 13 may also be an internal node of a controller, and the functionality of providing the first control signal c1 as explained above may be integrated in controller 13.

Furthermore, at a measurement input 14 controller 11 is configured to receive a measurement signal m indicating an actual state of the phase change switch device 12, e.g. indicating whether phase change switch device 12 is switched on or off. Examples how such a measurement signal m may be generated will be explained further below. In case phase change switch device 12 comprises a plurality of phase change switches, different measurement signals m may be provided for different switches or different groups of switches.

Controller 11 further comprises a control logic 16 configured to generate a second control signal c2 to be output at a control output 15 to control heater 18 (or, in some embodiments, several second control signals c2 to control several heaters 18 in case of a plurality of phase change switches). Control logic 16 generates second control signal c2 based on first control signal c1 and measurement signal m. In particular, measurement signal m may provide feedback if, based on a particular second control signal c2, phase change switch device 12 is switched to the desired state indicated by the first control signal. If this is not the case, second control signal c2 may be maintained or modified until measurement signal m indicates that the desired state indicated by first control signal c1 is reached. For example, second control signal c2 may be modified such that a time duration for heating and/or a power (e.g. voltage and/or current) supplied for heating are changed.

As mentioned above in some embodiments second control signal c2 directly may be the current supply to heater 18, and in this case a pulse length of a current pulse or a magnitude of a current pulse may be modified. In other embodiments, second control signals c2 may for example provided to a driver (not shown in Fig. 1) which drives heater 18, and in this case second control signal c2 may indicate a required power, for example the proportional to a required power, and a driver may determine time duration and/or power based on the signal, and/or indicate a required time duration.

In other embodiments, for example the second control signal c2 is generated such that power to heater 18 is provided until the desired state as indicated by measurement signal m matches the desired state indicated by first control signal c1. In this way, it can be ensured that after the switching the actual state of phase change switch device 12 matches the desired state as indicated by first control signal c1 also in case of the variations discussed initially, i.e. in case the necessary heating, for example time duration or heating power, varies due to process variations or environmental variations. In other embodiments, in this way it may be made at least less probable that after the switching event the actual state does not match the desired state.

Fig. 2 is a flowchart illustrating a method according to an embodiment, which may for example be implemented using the controller discussed above. To avoid repetitions, the method of Fig. 2 will be explained referring to the above explanations for the system of Fig. 1. However, this is merely an example, and the method of Fig. 2 may also be implemented in different systems and/or with different controllers, for example in the systems and using the controllers which will be explained further below.

While the method of Fig. 2 is represented as a series of acts or events, the order of the events is not limited, and in particular the acts or the events may also be performed concurrently, repeatedly and/or in a loop.

At 20 the method comprises receiving a first control signal indicating a desired state of a phase change switch device, as explained for first control signal c1 of Fig. 1. At 21, the method comprises receiving a measurement signal indicating an actual state of the phase change switch device, for example as explained above for measurement signal m of Fig. 1.

At 22, the method comprises outputting a second control signal for controlling a heater (i.e. one or more heaters) of the phase change switch device based on the first control signal and the measurement signal, for example as explained for second control signal c2 of Fig. 1.

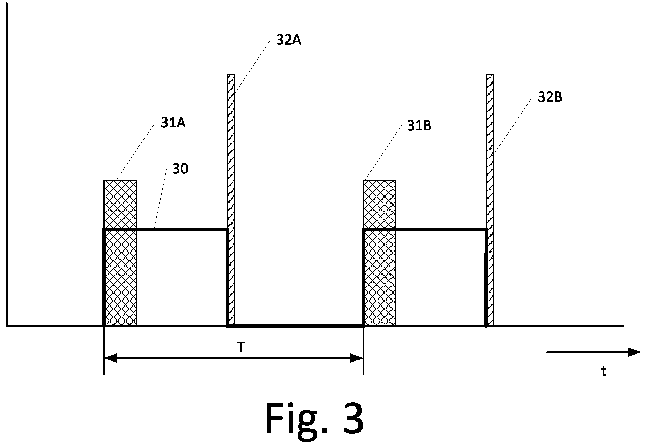

For further illustration, Fig. 3 shows an example for control signal c1 and a heating performed in response thereto in the embodiment of Fig. 1 or the embodiments discussed further below. A curve 30 indicates an example for first control signal c1 indicating the desired state of the phase change switch device, i.e. an example for control signal c1. A rising edge of signal 30 indicates that the phase change switch device should be switched from off to on, i.e. brought to the crystalline state, and a falling edge indicates that it should be switched from on to off, i.e. brought to the amorphous state.

T indicates a period of signal 30, i.e. a time duration from one rising edge to a next rising edge. It should be noted that signal 30 need not be periodic, as the requirement when a switching is performed may vary over time.

31A, 31B indicate supply pulses provided to a heater for setting to the crystalline state, i.e. switching the phase change switch device on, and 32A, 32B indicate pulses for switching the phase change switch off, i.e. to an amorphous state. Generally, for switching to the crystalline state, lower voltages/powers and longer time durations are required, whereas for setting to the amorphous state typically higher voltages/powers and lower time durations are required. In each case, a certain energy (for example 300-600 nJ) has to be transferred into the heater to reach the crystalline and amorphous state.

The voltage of the pulses can be calculated by a formula based on a linear approach:

$$\mathrm{V_{pulse}} = V_{supply} = \sqrt{\frac{E}{T} * R_{heat}} * \left(1 + \frac{R_{dson}}{R_{heat}}\right)$$

, where E is the energy transferred to pulse, T is the period of the pulse, $R_{dson}$ is the series resistance of a pass element via which the pulse is provided, and $R_{heat}$ is the heater resistance.

In conventional devices, the properties of the pulses 31A, 31B, 32A and 32B are set. In the embodiments discussed above, based on the measurement signal, the time duration and/or voltage (and consequently power) of the pulses 31A, 32A, 31B, 32B may be varied as explained above.

For example, if according to the measurement signal pulse 31A had to be prolonged to turn the phase change switch device on, the next pulse 31B may have a longer duration from the start, or in each case the pulse duration may be prolonged until the phase change switch device is turned on. For pulses 32A, 32B, if for example one pulse was not sufficient to switch the phase change switch off, a next pulse may be applied with a higher voltage, or the voltage may be increased during the pulse, or the pulse may be prolonged.

Typical parameter for pulses 31A, 31B are durations of the order of some microseconds and voltages of about 1.4-2.2 V, and for pulses 32A, 32B a pulse width of the order of 500 ns with voltages between about 1.8 and 2.8 V are required, for PCM switches with a width of approximately 30 um. The slope of the falling edge of the amorphous pulse typically is less than 50 ns. However, these are merely example values, which may vary depending on design.

Next, further example implementations of various embodiments will be described.

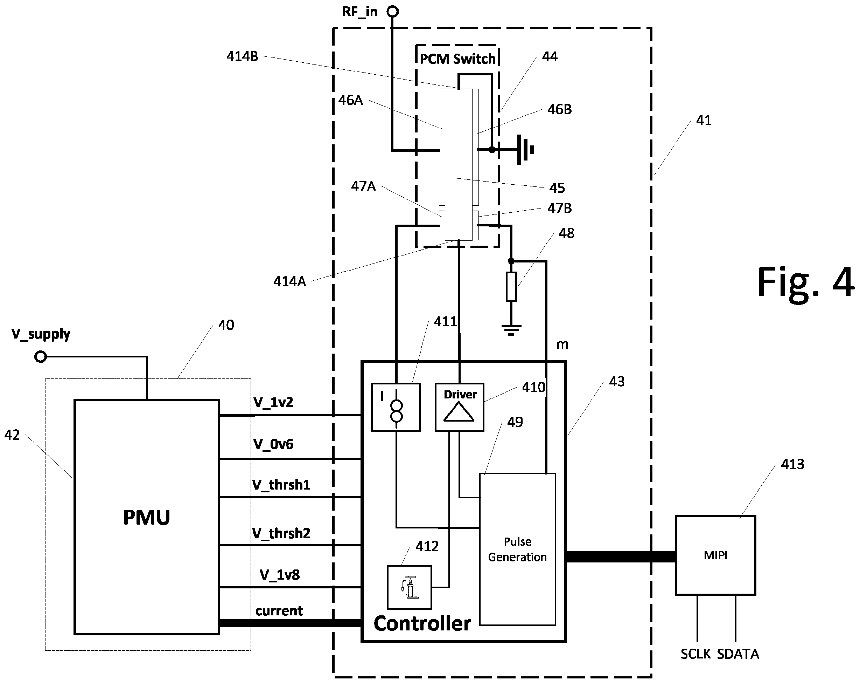

Fig. 4 illustrates a system including a controller 43 and a PCM switch device 44, together denoted with reference numeral 41. A supply unit 40 is provided including a power management unit 42 to provide block 41 with voltages and currents based on a supply voltage $V_{supply}$. For example, based on a supply voltage $V_{supply}$ PMU 42 may generate various voltages like voltages of 0.6 V, 1.2 V, 1.8 V (V_0v6, V_1v2, V_1v8), threshold voltages V_thrsh1 and V_thrsh2 as well as a current signal, or any other signal required to supply block 41.

Furthermore, for receiving the first control signal, a MIPI (mobile industry processor interface alliance) interface 413 is provided configured to receive a clock signal SCLK and a data signal SDATA as specified in the MIPI standard, where the desired state of phase change switch device 44 is encoded in the data signal SDATA.

PCM switch device 44 includes a PCM switch having a phase change material 45 as well as a heater (not explicitly shown, e.g. below phase change material 45 in Fig. 4) adjacent to the phase change material 45. First and second electrodes 46A, 46B are provided contacting phase change material 45. Fig. 4 shows an example shunt configuration, where electrode 46A is coupled to a radio frequency (RF) signal input RF_in and electrode 46B is coupled to ground, such that depending on the state of phase change material 45 RF input RF_in is coupled to or decoupled from ground.

Additionally, measurement electrodes 47A, 47B are provided spaced apart from electrodes 46A, 46B to form a measurement path.

While the heater is not explicitly shown, heater terminals 414A, 414B are shown in Fig. 4, which do not contact phase change material 45, but contact a heater arranged adjacent (e.g. below) to phase change material 45.

Measurement electrodes 47A, 47B serve to provide a measurement signal (for example signal m of Fig. 1) indicating an actual state of PCM switch device 44 to controller 43. To this end, in the example of Fig. 4 controller 43 includes a current source 411 which provides a measurement current. Via a shunt resistor 48, the controller may measure a corresponding voltage as measurement signal m. A high voltage may indicate an on-state of PCM switch device 44 (high current flow), whereas a low voltage (low or no current flowing) indicates an off-state. In other embodiments a constant voltage may be applied, and the current may be measured. The voltage measured may be compared to threshold voltages V_thrsh1, V_thrsh2 to determine the state. In yet other embodiments, as will be explained further below, the main path may be used for sensing.

A pulse generation logic 49, based on measurement signal m and the desired state of phase change switch device 44 received via MIPI interface 413, generates a pulse for the heater of phase change material 44. The pulse is then provided to a driver 410, which may be supplied by a higher voltage then can be delivered by a higher voltage then can be delivered by PMU 42 using a charge pump 412, for example to provide high voltages necessary for pulses 32A, 32B of Fig. 3. Driver 410 then outputs a corresponding pulse to heater terminal 414A, while heater terminal 413B is coupled to ground, such that a current flows through heater, heating phase change material 45. In this way, the state of phase change switch 44 is switched. As already explained above, based on measurement signal m the pulse generated by pulse generation logic 49 may be modified, for example extended until a switch off of the switch occurs or repeated possibly with higher or lower voltage, until a switch off of PCM switch device 44 occurs.

An example implementation of controller using a low drop out(LDO) controller with a PMOS pass element will be explained below in more detail.

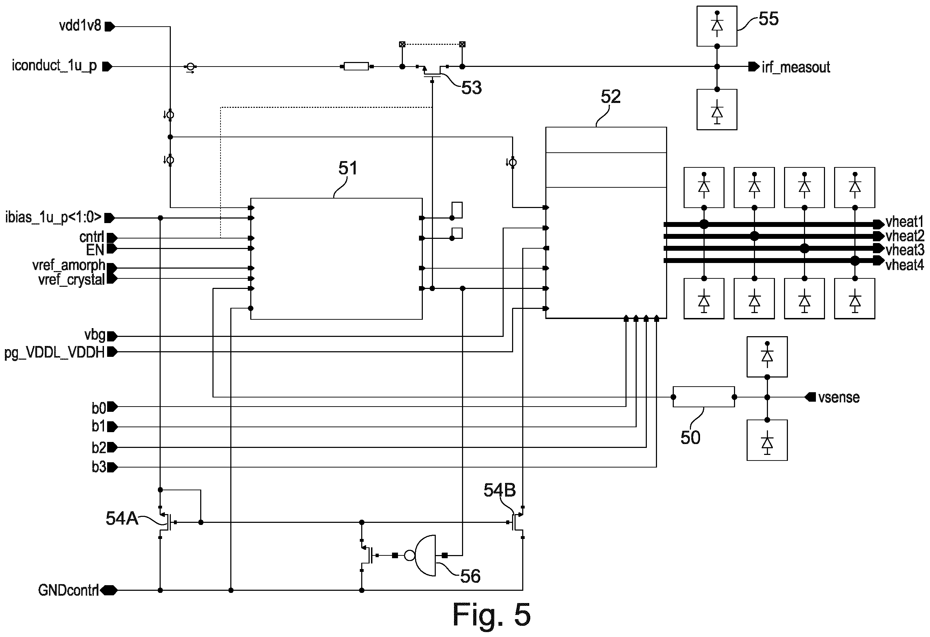

The controller shown in Fig. 5 comprises a logic block 51, a NMOS serial switch 53 for applying a reference current for sensing the state of the phase change material(e.g. corresponding to element 411 of Fig. 4) , a LDO pulse generation block 52, an ESD protection circuit 50 and a current mirror 54A, 54B. Block 52 generates output signals provided to a driver, in the example of Fig. 5 on four channels, to for example control four PCM switches separately. Elements 55 serve for ESD protection of the inputs and outputs. Via an inverter 56, the current mirror may be deactivated. Using the current mirror, a driver current may be provided to block 52.

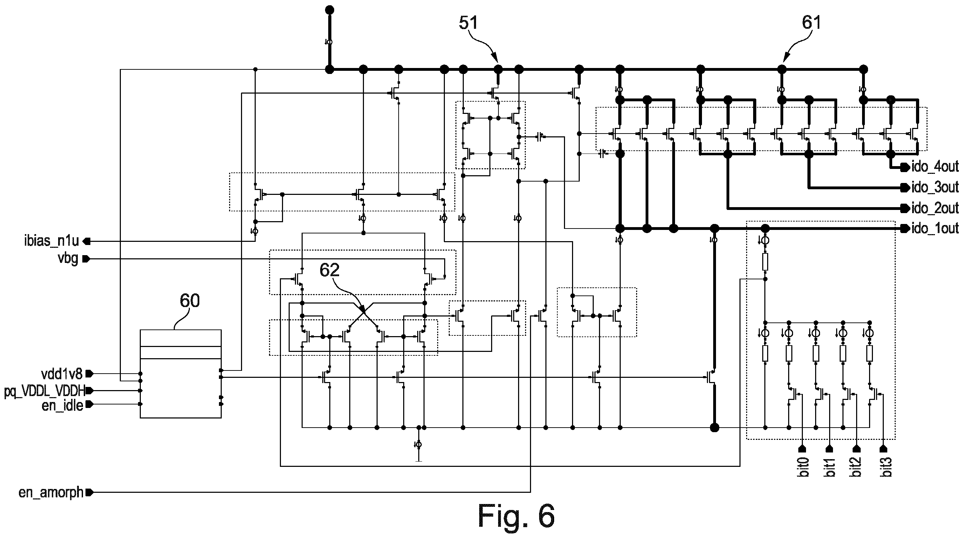

Fig. 6 is a more detailed example implementation of pulse generation block 52 of Fig. 5.

In embodiments, drivers 61 comprising PMOS pass elements supply e.g. approximately 250 mA for the amorphous pulse (for example pulses 32A, 32B of Fig 3) and approximately 200 mA for the crystalline pulse (for example pulses 31A, 31B of Fig. 3). For example, a plurality of transistor cells, , for example 120 transistor cells (in Fig. 6 three transistor cells are shown for each channel), may be connected in parallel to ensure sufficient current carrying capacity of the drivers.

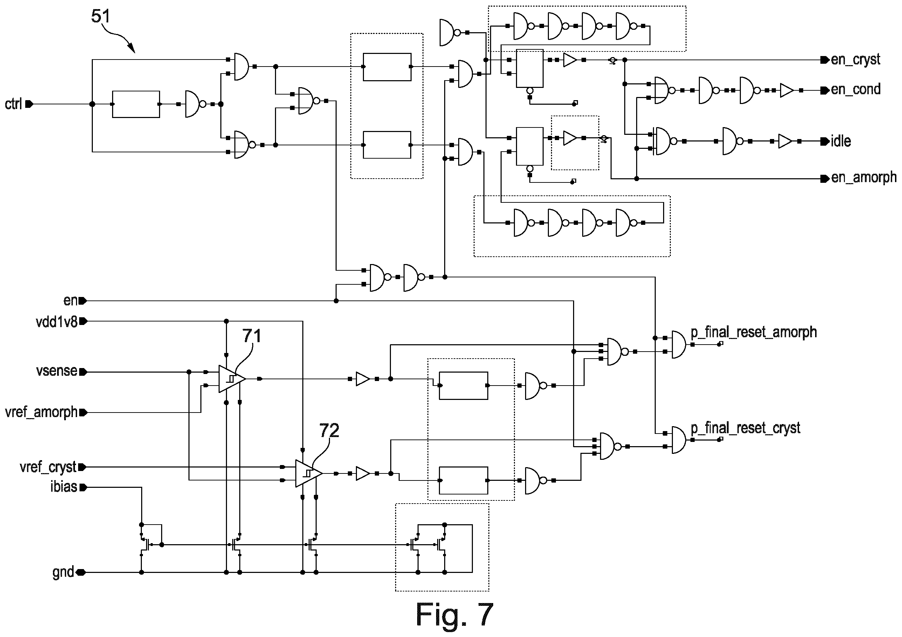

Fig. 7 shows an example implementation of logic block 51 of Fig. 5. Comparators 71, 72 may be used to compare the measurement signal received based on a voltage drop across a measurement resistor in response the measurement current generated via NMOS serial switch 53 in Fig. 5 to threshold values, to determine the state of the phase change switch, for example threshold values V_thrsh1 and V_thrsh2 of Fig. 4.

The low drop out controller with PMOS pass element discussed above can be switched into three possible states as follows:

- Amorphous state: The gate of the PMOS pass transistor is pulled to ground, i.e. the regulator is put out of function and the low drop out controller has the operating voltage - $V_{RDSon}$ as output voltage, e.g. Vsupply.

- Crystalline state: Normal LDO function with an activated error amplifier The error amplifier essentially measures the pulse height as a voltage as is implemented by the circuit part including cross-coupled transistors 62 in Fig. 6. The output voltage can be digitally adjusted with 4 bits of the MIPI bus from 0.7 V to 2.2 V, for example.

- Idle: In this mode, the complete LDO controller is switched to a power down mode, and the controller does not draw any current. In other words, the controller may be at least partially switched off (idle state) when the first control signal does not indicate a desired state of the phase change switch device, and therefore no heating is required.

The error amplifier mentioned above may be designed in such a way that it has a high slew rate when switching from high to low and vice versa, but does not overshoot due to a high phase reserve. A current sink additionally ensures that voltage peaks, which may occur when switching to the PMOS pass element 53, are supressed. A resistance of a lower part of the voltage divider provided in a feedback branch of the error amplifier may be adjusted via the MIPI bus with 4 bits and thus the output voltage of the LDO or the pulse height of the crystalline pulse can be adapted. The logic part of the circuit shown in Fig. 7 provides the input and switching signals of the LDO for the amorphous, crystalline, and idle mode states.

For this purpose, in embodiments it is evaluated when the PCM switch device becomes conductive, for example using the measurement discussed with respect to Fig. 4 above using shunt resistor 48 or any of the measurement approaches below, to determine how long the heating by the respective pulses has to occur.

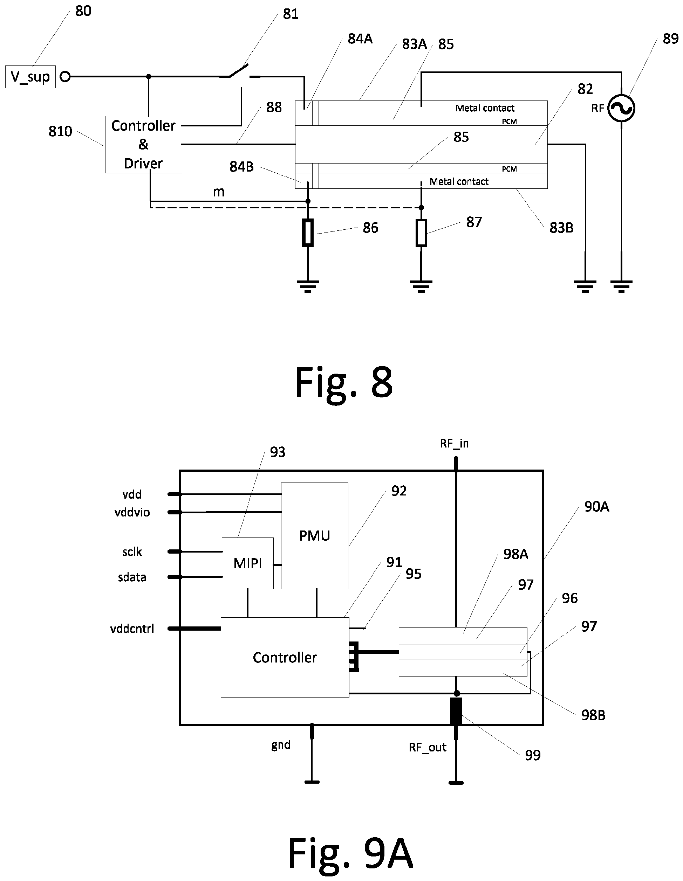

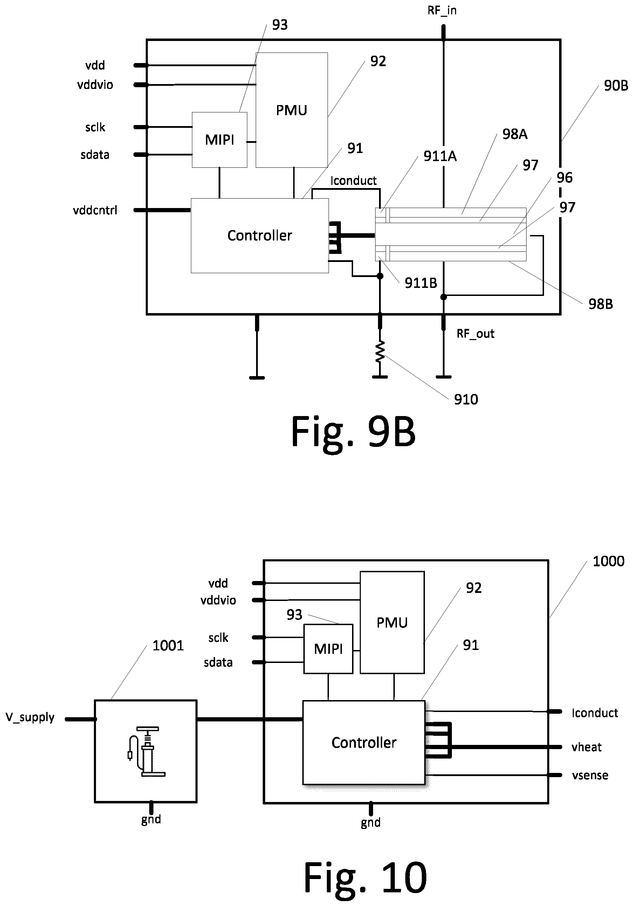

This measurement will now be explained in some more detail referring to Figures 8, 9A and 9B.

Fig. 8 illustrates a system according to a further embodiment.

The system of Fig. 8 includes a phase change switch including a heater 82, for example of tungsten, and a phase change material 85 provided above heater 82. In particular, in Fig. 8 the phase change switch is seen from below (compared to the orientation of Fig. 1), such that in the view shown in Fig. 8 phase change material 85 is "behind" heater 82 and partially hidden from view by heater 82.. Metal electrodes 83A, 83B which corresponds to electrodes 46A, 46B of Fig. 4 serve as contacts for an RF signal to be switched, and additional separate measurement electrodes 84A, 84B are provided. In the example of Fig. 8, also the phase change material 85 is divided, such that the measurement electrodes 84A, 84B have separate phase change material adjacent thereto. The area of the measurement electrodes 84A, 84B and the corresponding phase change material 85 may be significantly smaller, for example at least 50% smaller, at least 5 time smaller or at least 10 times smaller, than the one of metal electrodes 83A, 83B. The assumption here is that when heater 82 is actuated, the phase change material 85 reacts in the same manner, irrespective of whether it is contacted by electrodes 83A, 83B or measurement electrodes 84A, 84B, such that the state of the phase change material measured via measurement electrodes 84A, 84B corresponds to the state of the main phase change switch.

Similar to Fig. 4, Fig. 8 shows a shunt configuration where an RF signal applied to electrode 83A and symbolized by an RF source 89 is selectively coupled to ground.

Heater 82 is operated by a controller and driver 810 for example by the controllers and drivers discussed above, via a connection 88. For obtaining the measurement signal m, in some embodiments a voltage, for example supply voltage 80, is temporarily applied to electrode 84A by closing a switch 81, and using a shunt resistor 86 a corresponding current (converted to a voltage by shunt resistor 86) is measured as measurement signal m. A low or negligible current may indicate an off-state of the phase change switch, whereas a high current (for example above a threshold) may indicate an on-state of the phase change switch.

Then, controller 810 outputs the heating pulse to heater 82 based on the measurement signal m and a desired state of the PCM switch, as explained previously.

Alternatively, electrode 84A and 84B may also be omitted, and the state of the phase change switch may be measured via a resistor 87, when the voltage 80 is supplied to electrode 83A, where resistor 87 may be a resistor having a small resistance (for example even just a copper wire) so that the regular operation of the switch outside switching periods is essentially not disturbed. Instead of a constant voltage, also a measurement current may be applied.

The two possibilities for measurement are again explained referring to Figures 9A and 9B.

Fig. 9A illustrates a system including a controller 91, a phase change switch (reference numerals 96-98A,B), a MIPI interface 93 and a power management unit 92. Power management unit 92 and MIPI interface 93 operate as explained for power management unit 42 and MIPI interface 413 in Fig. 4. The phase change switch of Fig. 9A includes a heater 96, phase change material 97 arranged adjacent to the heater (e.g. below heater 96 as explained for Fig. 8), a first electrode 98A and a second electrode 98B. Therefore, the phase change switch of Fig. 9A corresponds to the phase change switch of Fig. 8 without the measurement electrodes 94A, 94B and the corresponding phase change material.

Controller 91 receives a first control signal via MIPI interface 93, as explained previously, and receives necessary voltages or currents from power management unit 92. Furthermore, to measure the actual state of the phase change switch, a measurement resistor 99 is provided in the RF path. This corresponds to measurement resistor 87 of Fig. 8. Here no separate path for measuring the state is provided, but the RF path itself is used for measuring the actual state of the phase change switch, for example by applying a test signal to an input RF_in or by simply measuring a voltage at resistor 99 in operation while an RF signal is applied to RF_in. The resistance of measurement resistor 99 may be small, for example in the order of a few Ohm.

Fig. 9B shows the case of using a specific measurement electrodes, as also already explained with respect to Fig. 8. Here, separate measurement electrodes 911A, 911B corresponding to electrodes 84A, 84B are provided, and controller 91 applies a test current Iconduct to measurement electrode 911A. Using a measurement resistor 910, a measurement signal indicative of the actual state of the phase change switch may then be obtained. In both cases, controller 91 then controls heater 96 based on the desired state and the actual state indicated by the measurement signal, as already explained.

Fig. 10 illustrates a controller arrangement 1000 according to a further embodiment, which is a variation of the controller discussed with reference to Figures 9A and 9B, and corresponding elements bear the same reference numerals. In Fig. 10, the phase change switch is not shown, and may be configured as in Fig. 9A or 9B. Controller 91 receives a measurement signal, in this case a voltage Vsense, may output the measurement current Iconduct and outputs a voltage for heating, designated Vheat as an example for the second control signal in Fig. 10.

In addition to the components discussed with reference to Figures 9A and 9B in Fig. 10 additionally a charge pump 1001 is provided. Alternatively, to charge pump 1001, a DC/DC converter like a boost converter may be provided. Using charge pump 1001 a higher supply voltage may be provided to controller 91, for example in case the voltage Vheat has to be higher than the supply voltage (which for example may be 3.3 Volt supply voltage) may be provided.

The current Iconduct may for example always be activated when the first control signal indicating the desired state received via the MIPI interface 93 indicates a change of state, i.e. when the state is to be changed. In other embodiments, the current may also be always active. The measurement signal may for example be evaluated by two comparators (for example comparators 71, 72 of Fig. 7) and compared to different threshold values, where for example a higher reference voltage represents that the PCM switch is conductive (crystalline), whereas a lower reference voltage represents an amorphous state, and heating may be performed until the desired state is obtained, or, in case of switching to the amorphous state, corresponding heating pulses may be repeated and possibly modified until the desired state is obtained.

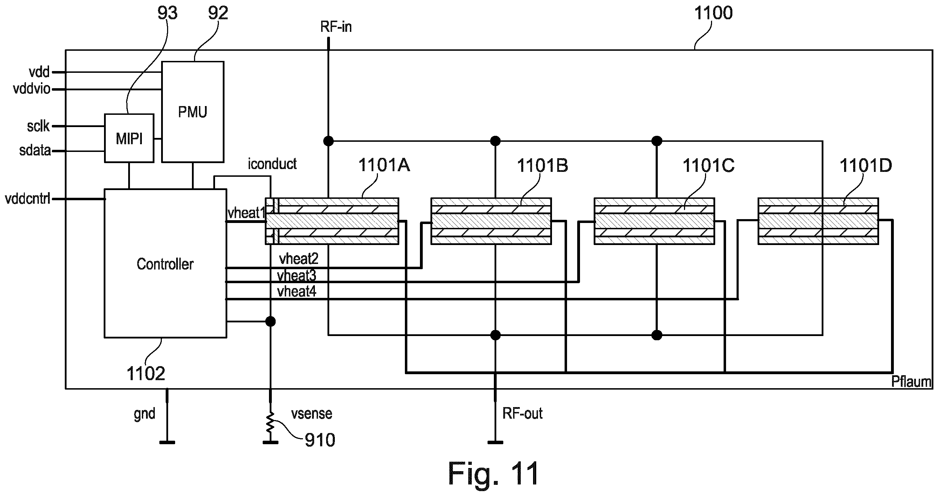

The above discussed embodiment used phase change switch devices including a single phase change switch. In other embodiments, a plurality of phase change switches may be provided in a phase change switch device, where all phase change switches or groups of phase change switches may share the same controller. For instance, to reduce the on resistance, several phase change switches may be coupled in parallel between an input and an output, for example an RF input and ground, and/or to increase the voltage handling capability, phase change switches may be coupled in series. Fig. 11 illustrates a system 1100 where for phase change switches 1101A to 1101D are coupled in parallel between an RF input RF_in and RF output RF_out, the latter in the example of Fig. 11 being coupled to ground in a shunt configuration. Furthermore, the system includes a controller 1102 a MIPI interface 93 and a power management unit 92. Controller 1102, MIPI interface 93 and PMU 92 operate similar to controller 91, MIPI 93 and PMU 92 of Fig. 9B, with the difference that controller 1102 has four outputs for outputting corresponding pulses to each of phase change switches 1101A to 1101D. In the embodiment of Fig. 11, phase change switch 1101A is designed as the phase change switch of Fig. 9B, i.e. with separate measurement electrodes, and a measurement current Iconduct is supplied and a sense voltage Vsense is sensed at a resistor 910, as explained with reference to Fig. 9B. The remaining phase change switches 1101B to 1101D do not have such measurement electrode, and their state is not measured. In the system 1100, it is instead assumed that due to the spatial proximity the environment conditions, for example temperature, are essentially the same for all phase change switches 1101A to 1101D, and they are for example manufactured jointly such that manufacturing tolerances also essentially apply to all phase change switches. Therefore, when the same heater pulses are applied to all phase change switches, it may be assumed that the state of phase change switches 1101B to 1102D corresponds to the state of phase change switch 1101A. Therefore, in the embodiment of Fig. 11 only the state of phase change switch 1101A is measured. In other embodiments, the state of more than one phase change switch or the state of all phase change switches may be measured separately.

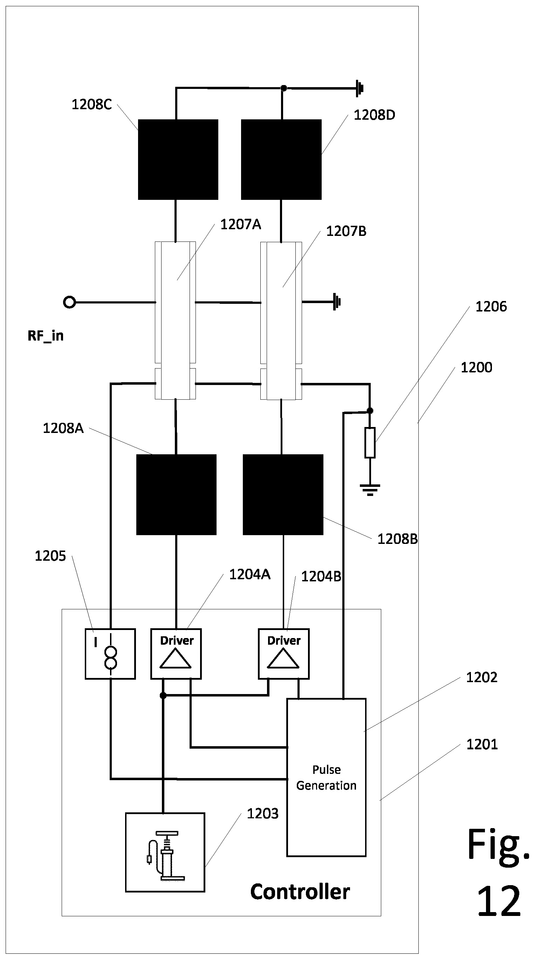

Fig. 12 illustrates an example where two phase change switches 1207A, 1207B are stacked in a system 1200 i.e. coupled in series between an input RF_in and ground (in Fig. 12) or another RF output. The number of two stacked phase change switches is merely an example, and other numbers of stacked phase change switches, e.g. to obtain a desired voltage handling capability, may also be used in this and other embodiments discussed herein. A controller 1201 includes a pulse generation unit 1202, a charge pump 1203, a measurement current source 1205 and drivers 1204A, 1204B. Controller 1201 essentially corresponds to controller 43 of Fig. 4, with two drivers 1204A, 1204B providing pulses to the heaters of the phase change switches 1207A, 1207B instead of a single driver being provided.
Both phase change switches 1207A, 1207B include separate measurement electrodes as explained previously, which are also coupled in series and to which the measurement current is applied by current source 1205. Using a measurement resistor 1206, a measurement signal indicating a state of the series connection of phase change switches 1207A, 1207B is provided, and the driving of the heaters may be on a desired state and this measurement signal, as already discussed.

Optionally, elements 1208A, 1208B, 1208C and 1208D are provided coupled in series to the heater, both between driver the respective driver 1204A, 1204B and the heater and between the heater and ground as shown. Elements 1208A to 1208D may for example include auxiliary switches or p-i-n diodes, as explained further below.

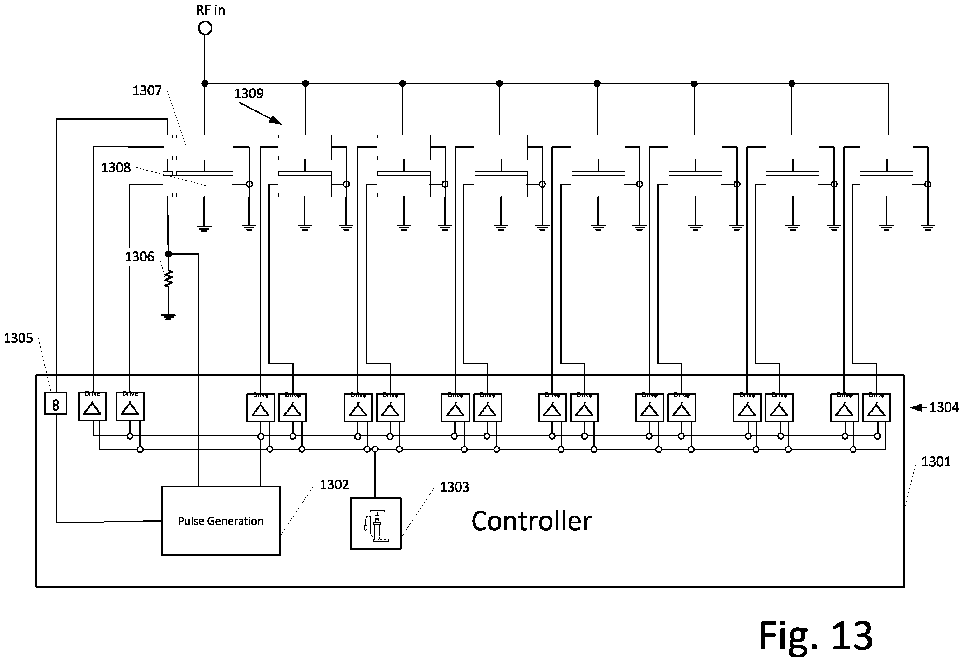

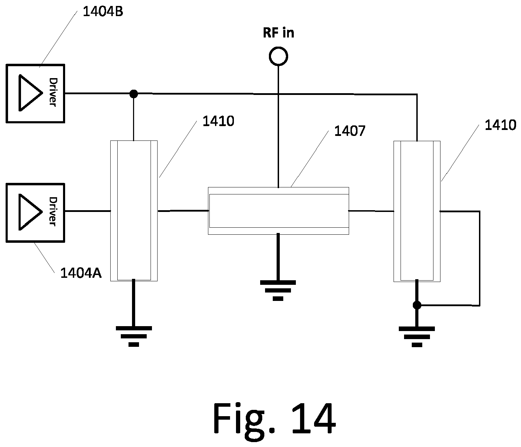

Fig. 13 illustrates a system which combines a parallel coupling and a series coupling. A controller 1301 includes a pulse generation unit 1302, a charge pump 1303 and a constant current source 1305 for providing a measurement current. Drivers 1304 are provided for each of phase change switches 1307, 1308 and 1309. As can be seen in Fig. 13, the phase change switches are arranged in a parallel connection of eight pairs of phase change switches, each pair being coupled in series. These numbers are merely examples, and more than two phase change switches may be coupled in series, and more or less than 8 pairs (or other series connections) may be coupled in parallel. Phase change switches 1307, 1308 comprise separate measurement and electrodes, to which a measurement current provided by a current source 1305 is applied, and a measurement signal is measured using a shunt resistor 1306 as explained previously. Based on a desired state (for example received from a MIPI interface as explained previously) and the measurement signal, pulse generation unit 1302 may provide signals to drivers 1304 to switch the phase change switches 1307, 1308, 1309 to a desired state. As briefly mentioned with respect to Fig. 12, additional components 1208A to 1208D may be provided. One possibility are auxiliary phase change switches. This is schematically shown in Fig. 14. A main phase change switch 1407 serves for switching an RF path, and its heater is driven by a driver 1404A. Auxiliary phase change switches 1410 are provided which are switched on by a driver 1404B when a heater pulse is to be applied to heater 1407 by driver 1404A, and are switched off otherwise. These auxiliary switches in some embodiments may provide a better isolation for the heater of phase change switch 1407 outside heating periods of the heater of phase change switch 1407, which may protect the driver from high voltages (e.g. up to 100V) at the input of the heater.

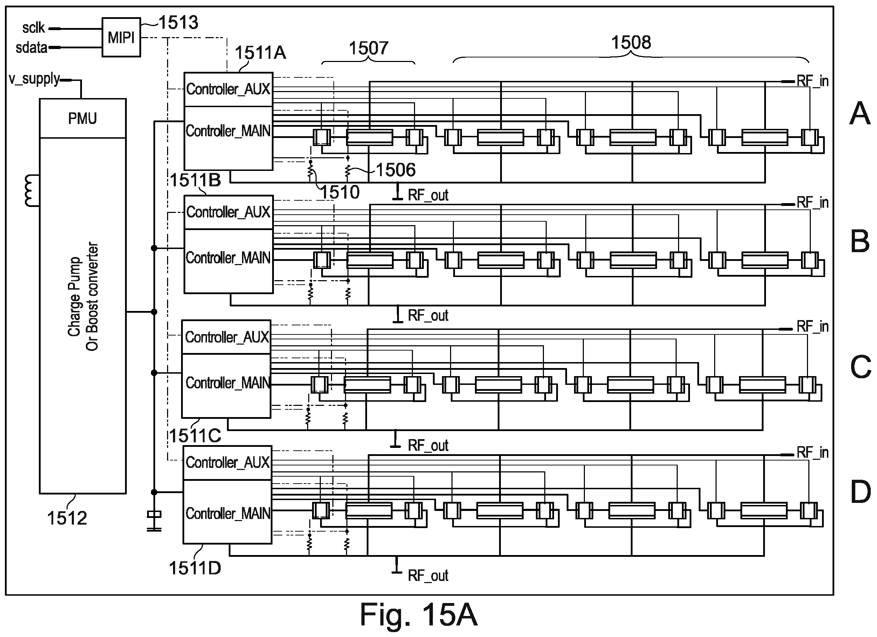

Fig. 15A illustrates an example system in a 4x single throw single pole configuration, i.e. four RF inputs which are selectively coupled to ground, by 4 phase change switches coupled in parallel. Again, this configuration is merely an example.For each group A to D of 4 switches, a respective controller 1511A to 1511B is provided. A desired state of the respective switch group is provided via a MIPI interface 1513 to all four controllers 1511A to 1511D and a single charge pump or boost converter and a single PMU 1512 supply voltages or currents needed.

In a first phase change switch arrangement (main switch and two auxiliary switches) 1507 of each switch group A to D, measurement electrodes are provided at the respective main RF switch (switch 1407 in Fig. 14) and one of the auxiliary switches (one of switches 1410 in Fig. 14), such that the actual state of the main switch and the auxiliary switches may be measured. The state of switch arrangements 1508 is not measured, but assumed to be the same as the state of switch arrangement 1507 of the respective group. The actual state of the main switches is measured via a shunt resistor 1506, and the actual state of the auxiliary switches is measured by a shunt resistor 1510.

Each controller 1511A to 1511D comprises a sub-controller (Controller_MAIN) for the respective main switch (for example operating driver 1404A of Fig. 14), and an auxiliary controller (Controller_AUX, for example operating driver 1404B of Fig. 13), for switching the auxiliary switches.

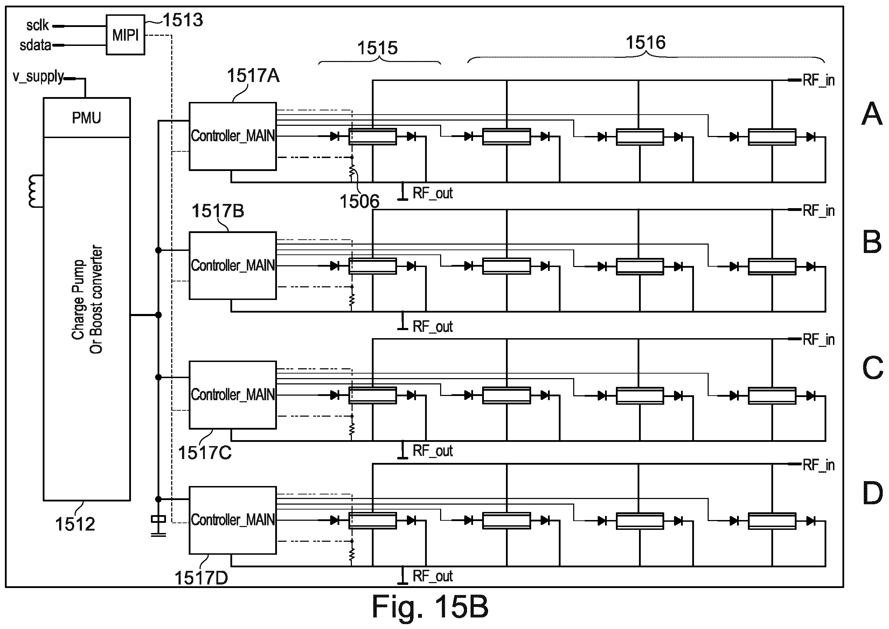

Fig. 15B shows a variation of the embodiment of Fig. 15A, where the auxiliary switches are replaced by diodes, e.g. p-i-n diodes. In a first PCM switch of each group A to D, denoted reference numeral 1515, the state is measured via a shunt resistor 1506. As no auxiliary switches are provided, controllers 1517A to 1517D only include a main controller for each group A to D. The state of switches 1516 is not measured.

While measurements via shunt resistors are shown in the embodiments of Figures 11 to 15A, 15B, in other embodiments for example also a direct measurement as shown in Fig. 9B may be used. Besides shunt resistors for current or voltage measurements, other types of measurements, for example magnetic field-based current measurements may also be used. Furthermore, while heaters are supplied in parallel by a controller e.g. in Figs. 15A and 15B, they may also be coupled in series to be supplied with power.

Some embodiments are defined by the following examples:

Example 1. A controller for a phase change switch device comprising:

a control input configured to receive a first control signal indicating a desired state of the phase change switch device,

a measurement input configured to receive a measurement signal indicating an actual state of the phase change switch device,

a control output configured to output a second control signal to at least one heater of the phase change switch device, and

a control logic configured to generate the second control signal based on the first control signal and the measurement signal.

Example 2. The controller of example 1, wherein the second control signal is indicative of at least one of a time duration or electrical power to be supplied to the at least one heater for heating, wherein the control logic is configured to determine the time duration and electrical power based on the desired state indicated by the first control signal and the measurement signal.

Example 3. The controller of example 2, wherein the control logic is configured to generate the second control signal to supply electrical power to the heater until the measurement signal indicates that the actual state matches the desired state.

Example 4. The controller of example 2, wherein the control logic is configured to generate the second control signal providing a first time duration and a first electrical power based on the first control signal, and, if after the first electrical power has been applied during the first time duration to the heater, the measurement signal indicates that the actual state of the phase change switch device is different from the desired state, to generate the second control signal providing a second time duration and a second electrical power, wherein at least one of the second time duration or the second electrical power differs from the first time duration or first electrical power, respectively.

Example 5. The controller of example 2, wherein the second time duration is longer than the first time duration, or the second electrical power is higher than the first electrical power.

Example 6. The controller of any one of examples 1 to 5, further comprising a power input configured to receive electrical power, wherein the second control signal is configured to be directly provided to the at least one heater to provide electrical power derived from the electrical power received at the power input to the heater.

Example 7. The controller of any one of examples 1 to 6, further comprising a low dropout regulator.

Example 8. The controller of any one of examples 1 to 7, wherein the control logic is configured to be at least partially switched off when the first control signal does not indicate a change of the desired state.

Example 9. A system, comprising:

the controller of any one of examples 1 to 8, and
the phase change switch device.

Example 10. The system of example 9, wherein the phase change switch device comprises at least one first phase change switch including a heater coupled to the control output of the controller, a first electrode pair coupled to the measurement input, a second electrode pair coupled to terminals of the phase change switch device, and a phase change material thermally coupled to the heater and electrically coupled to the first electrode pair and the second electrode pair.

Example 11. The system of example 10, wherein an area of the phase change material covered by the first electrode pair is at least 50% smaller than an area of the phase change material covered by the second electrode pair.

Example 12. The system of example 10 or 11, wherein the phase change switch device comprises at least one second phase change switch including a heater coupled to the control output of the controller, an electrode pair coupled to terminals of the second phase change switch, and a phase change material thermally coupled to the heater and arranged between and electrically coupled to the electrode pair, wherein the at least one second phase change switch is not coupled to the measurement input.

Example 13. The system of example 12, wherein signal paths of the at least one first phase change switch and the at least one second phase change switch are coupled in a parallel configuration, a serial configuration or a parallel/serial configuration.

Example 14. The system of example 12 or 13, wherein heaters of the at least one first phase change switch and the at least one second phase change switch are coupled in a parallel configuration, a serial configuration or a parallel/serial configuration.

Example 15. The system of any one of examples 9 to 13,
wherein the controller is the controller of example 6 or 7, further comprising a charge pump coupled to the power input of the controller.

Example 16. The system of any one of examples 9 to 14, further comprising a MIPI interface coupled to the control input of the controller.

Example 17. A method for controlling a phase change switch device comprising:

receiving a first control signal indicating a desired state of the phase change switch device,
receiving a measurement signal indicating an actual state of the phase change switch device,
generating a control signal based on the first control signal and the measurement signal, and
outputting the second control signal to at least one heater of the phase change switch device.

Example 18. The method of example 17, wherein the second control signal is indicative of at least one of a time duration or electrical power to be supplied to the at least one heater for heating, wherein the method further comprises determining the time duration and electrical power based on the desired state indicated by the first control signal and the measurement signal.

Example 19. The method of example 18, wherein generating the second control signal comprises generating the second control signal to supply electrical power to the heater until the measurement signal indicates that the actual state matches the desired state.

Example 20. The method of example 18, wherein generating the second control signal comprises generating the second control signal providing a first time duration and a first electrical power based on the first control signal, and, if after the first electrical power has been applied during the first time duration to the heater, the measurement signal indicates that the actual state of the phase change switch device is different from the desired state, generating the second control signal providing a second time duration and a second electrical power, wherein at least one of the second time duration or the second electrical power differs from the first time duration or first electrical power, respectively.

Example 21. The method of example 20, wherein the second time duration is longer than the first time duration, or the second electrical power is higher than the first electrical power.

Example 22. The method of any one of examples 17 to 21, further comprising receiving electrical power, wherein the second control signal is directly provided to the at least one heater to provide electrical power derived from the received electrical power to the heater.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

**Claims**

1.  A controller (11, 43, 810, 91, 1102, 1201, 1301, 1511A-D, 1517A-D) for a phase change switch device (12; 44) comprising:

    a control input (13) configured to receive a first control signal (c1) indicating a desired state of the phase change switch device (12; 44),
    a measurement input (14) configured to receive a measurement signal (m; Vsense) indicating an actual state of the phase change switch device (12; 44),
    a control output configured to output a second control signal to at least one heater (18; 82; 96) of the phase change switch device (12; 44), and
    a control logic configured to generate the second control signal based on the first control signal (c1) and the measurement signal (m; Vsense).

2.  The controller (11, 43, 810, 91, 1102, 1201, 1301, 1511A-D, 1517A-D) of claim 1, wherein the second control signal (c2) is indicative of at least one of a time duration or electrical power to be supplied to the at least one heater (18; 82; 96) for heating, wherein the control logic is configured to determine the time duration and electrical power based on the desired state indicated by the first control signal (c1) and the measurement signal (m; Vsense).

3.  The controller (11, 43, 810, 91, 1102, 1201, 1301, 1511A-D, 1517A-D) of claim 2, wherein the control logic is configured to generate the second control signal to supply electrical power to the heater (18; 82; 96) until the measurement signal (m; Vsense) indicates that the actual state matches the desired state.

4.  The controller (11, 43, 810, 91, 1102, 1201, 1301, 1511A-D, 1517A-D) of claim 2, wherein the control logic is configured to generate the second control signal providing a first time duration and a first electrical power based on the first control signal (c1), and, if after the first electrical power has been applied during the first time duration to the heater (18; 82; 96), the measurement signal (m; Vsense) indicates that the actual state of the phase change switch device (12; 44) is different from the desired state, to generate the second control signal providing a second time duration and a second electrical power, wherein at least one of the second time duration or the second electrical power differs from the first time duration or first electrical power, respectively.

5.  The controller (11, 43, 810, 91, 1102, 1201, 1301, 1511A-D, 1517A-D) of claim 4, wherein the second time duration is longer than the first time duration, or the second electrical power is higher than the first electrical power.

6.  The controller (11, 43, 810, 91, 1102, 1201, 1301, 1511A-D, 1517A-D) of any one of claims 1 to 5, further comprising a power input configured to receive electrical power, wherein the second control signal is configured to be directly provided to the at least one heater (18; 82; 96) to provide electrical power derived from the electrical power received at the power input to the heater (18; 82; 96).

7. The controller (11, 43, 810, 91, 1102, 1201, 1301, 1511A-D, 1517A-D) of any one of claims 1 to 6, further comprising a low dropout regulator.

8. The controller (11, 43, 810, 91, 1102, 1201, 1301, 1511A-D, 1517A-D) of any one of claims 1 to 7, wherein the control logic is configured to be at least partially switched off when the first control signal (c1) does not indicate a change of the desired state.

9. A system, comprising:

   the controller (11, 43, 810, 91, 1102, 1201, 1301, 1511A-D, 1517A-D) of any one of claims 1 to 8, and
   the phase change switch device (12; 44).

10. The system of claim 9, wherein the phase change switch device (12; 44) comprises at least one first phase change switch (1101A; 1307, 1307B; 1507; 1515) including a heater (18; 82; 96) coupled to the control output of the controller (11, 43, 810, 91, 1102, 1201, 1301, 1511A-D, 1517A-D), a first electrode pair (47A, 47B; 84A; 84B; 911A; 911B) coupled to the measurement input, a second electrode pair (46A, 46B; 83A, 83B; 98A, 98B) coupled to terminals of the phase change switch device (12; 44), and a phase change material (45; 85; 97) thermally coupled to the heater (18; 82; 96) and electrically coupled to the first electrode pair (47A, 47B; 84A; 84B; 911A; 911B) and the second electrode pair (46A, 46B; 83A, 83B; 98A, 98B).

11. The system of claim 10, wherein an area of the phase change material (45; 85; 97) covered by the first electrode pair (46A, 46B; 83A, 83B; 98A, 98B) is at least 50% smaller than an area of the phase change material (45; 85; 97) covered by the second electrode pair(46A, 46B; 83A, 83B; 98A, 98B) .

12. The system of claim 10 or 11, wherein the phase change switch device (12; 44) comprises at least one second phase change switch (1101B-D; 1309; 1508; 1516) including a heater (18; 82; 96) coupled to the control output of the controller (11, 43, 810, 91, 1102, 1201, 1301, 1511A-D, 1517A-D), an electrode pair coupled to terminals of the second phase change switch, and a phase change material thermally coupled to the heater (18; 82; 96) and arranged between and electrically coupled to the electrode pair, wherein the at least one second phase change switch is not coupled to the measurement input (14).

13. The system of claim 12, wherein signal paths of the at least one first phase change switch (1101A; 1307, 1307B; 1507; 1515) and the at least one second phase change switch (1101B-D; 1309; 1508; 1516) are coupled in a parallel configuration, a serial configuration or a parallel/serial configuration.

14. The system of claim 12 or 13, wherein heaters (18; 82; 96) of the at least one first phase change switch (1101A; 1307, 1307B; 1507; 1515) and the at least one second phase change switch (1101B-D; 1309; 1508; 1516) are coupled in a parallel configuration, a serial configuration or a parallel/serial configuration.

15. The system of any one of claims 9 to 13,

   wherein the controller (11, 43, 810, 91, 1102, 1201, 1301, 1511A-D, 1517A-D) is the controller (11, 43, 810, 91, 1102, 1201, 1301, 1511A-D, 1517A-D) of claim 6 or 7,
   further comprising a charge pump coupled to the power input of the controller (11, 43, 810, 91, 1102, 1201, 1301, 1511A-D, 1517A-D).

c1    13    11    14                              10              12    17

┌─────────────────────────────┐          ┌─────────────────────────────┐
│         ⊠                    │          │                       17    │
│                             ⊠│◄─── m ───│   Phase change material     │
│  controller                  │          │  Phase change switch device │
│                    15        │          │                             │  18
│  ┌────────────────┐         ⊠│─────────►│      heater                 │
│  │  control logic  │         │          │                             │
│  └────────────────┘         │          └─────────────────────────────┘
└─────────────────────────────┘
        16          c2

# Fig. 1

┌───────────────────────────────────────────────────────────────┐
│ Receive first control signal indicating desired state of a      │  20
│ phase change switch device                                      │
└───────────────────────────────────────────────────────────────┘
                              │
                              ▼
┌───────────────────────────────────────────────────────────────┐
│ Receive measurement signal indicating an actual state of the    │  21
│ phase change switch device                                      │
└───────────────────────────────────────────────────────────────┘
                              │
                              ▼
┌───────────────────────────────────────────────────────────────┐
│ Output second control signal for controlling heater based on    │  22
│ first control signal and measurement signal                     │
└───────────────────────────────────────────────────────────────┘

# Fig. 2

Fig. 3

Fig. 4

Fig. 5

Fig. 6

Fig. 7

en_cryst
en_cond
idle
en_amorph

p_final_reset_amorph
p_final_reset_cryst

51

71
72

ctrl

en
vdd1v8
vsense
vref_amorph
vref_cryst
ibias
gnd

# Fig. 8

# Fig. 9A

Fig. 9B

Fig. 10

Fig. 11

Fig. 12

Fig. 13

Fig. 14

Fig. 15A

Fig. 15B

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | EP 4 016 844 A1 (INFINEON TECHNOLOGIES AG [DE]) 22 June 2022 (2022-06-22)<br>* the whole document * | 1-3,6-9, 12-15<br>4,5,10, 11 | INV.<br>H03K17/14<br>H03K17/18<br>H10N70/20 |
| X<br><br>A | US 2006/181932 A1 (CHO WOO-YEONG [KR] ET AL) 17 August 2006 (2006-08-17)<br>* figures 4, 14 * | 1-3,6-9, 12-15<br>4,5,10, 11 | |
| X<br><br>A | US 9 646 692 B1 (LUNG HSIANG-LAN [TW] ET AL) 9 May 2017 (2017-05-09)<br>* figures 2-4 * | 1-3,6-9, 12-15<br>4,5,10, 11 | |
| A | US 2008/165571 A1 (LUNG HSIANG LAN [US]) 10 July 2008 (2008-07-10)<br>* figure 4 * | 8 | |

TECHNICAL FIELDS
SEARCHED      (IPC)

H03K
G11C
H02N
H10N

The present search report has been drawn up for all claims

| Place of search | Date of completion of the search | Examiner |
|---|---|---|
| The Hague | 12 January 2024 | Loiseau, Ludovic |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

**EP 23 18 9123**

This annex lists the patent family members relating to the patent documents cited in the above-mentioned European search report.
The members are as contained in the European Patent Office EDP file on
The European Patent Office is in no way liable for these particulars which are merely given for the purpose of information.

**12-01-2024**

| Patent document cited in search report | | Publication date | Patent family member(s) | | Publication date |
|---|---|---|---|---|---|
| EP 4016844 | A1 | 22-06-2022 | CN | 114650044 A | 21-06-2022 |
| | | | EP | 4016844 A1 | 22-06-2022 |
| | | | KR | 20220088338 A | 27-06-2022 |
| | | | US | 2022199343 A1 | 23-06-2022 |
| US 2006181932 | A1 | 17-08-2006 | CN | 1574093 A | 02-02-2005 |
| | | | DE | 102004025975 A1 | 30-12-2004 |
| | | | JP | 2004362761 A | 24-12-2004 |
| | | | US | 2004246804 A1 | 09-12-2004 |
| | | | US | 2006181932 A1 | 17-08-2006 |
| US 9646692 | B1 | 09-05-2017 | CN | 106875973 A | 20-06-2017 |
| | | | TW | 201735037 A | 01-10-2017 |
| | | | US | 9646692 B1 | 09-05-2017 |
| US 2008165571 | A1 | 10-07-2008 | NONE | | |

EPO FORM P0459

For more details about this annex : see Official Journal of the European Patent Office, No. 12/82